# FASCICULE DE BREVET EUROPEEN

(11) **EP 4 430 225 B1**
(45) Date de publication et mention de la délivrance du brevet: **22.04.2026**
(21) Numéro de dépôt: 22818096.4
(22) Date de dépôt: 09.11.2022
(51) Int. Cl.: C23C 16/04, C23C 16/32, C23C 16/46, C23C 16/455, C04B 35/565, C04B 35/80, C01B 32/977

(54) **PROCEDE DE DENSIFICATION PAR INFILTRATION CHIMIQUE EN PHASE VAPEUR**
VERFAHREN ZUR VERDICHTUNG DURCH CHEMISCHE DAMPFINFILTRATION
METHOD FOR DENSIFICATION BY CHEMICAL VAPOUR INFILTRATION

(30) Priorité: 10.11.2021 FR 2111929
(43) Date de publication de la demande: 18.09.2024
(73) Titulaire: Safran Ceramics, 33185 Le Haillan (FR)
(72) Inventeur: LAMOUROUX, Franck, 77550 MOISSY-CRAMAYEL (FR); DELCAMP, Adrien, 77550 MOISSY-CRAMAYEL (FR)
(74) Mandataire: Cabinet Beau de Loménie
(86) Numéro de dépôt international: PCT/FR2022/000099
(87) Numéro de publication internationale: WO 2023/084161

(56) Documents cités:
- FR-A1- 2 700 330
- KR-A- 20190 068 323
- US-A- 5 348 774
- US-A- 5 738 951
- US-A1- 2007 172 639
- US-A1- 2016 281 218
- US-A1- 2018 171 475
- US-A1- 2020 157 679

## Description

### Domaine Technique

L'invention concerne le domaine des matériaux composites, et plus précisément le domaine des procédés d'infiltration chimique en phase vapeur permettant d'obtenir ces matériaux par densification d'une préforme fibreuse.

### Technique antérieure

Les pièces en matériau composites connaissent un intérêt technologique croissant du fait du bon compromis qu'elles offrent en termes de résistance et de poids.

Il est connu d'obtenir des pièces en matériau composite par infiltration chimique ou par dépôt chimique en phase vapeur à partir d'une préforme fibreuse. De tels procédés utilisent une phase gazeuse réactive dont la décomposition permet la formation de la matrice souhaitée. Cette phase gazeuse réactive est introduite dans la porosité de préformes fibreuses elles-mêmes placées dans un four de densification, et les conditions du four sont choisies de telle sorte que la phase gazeuse se décompose et forme ainsi la matrice de la pièce en matériau composite directement dans la porosité des préformes fibreuses. Le choix du gaz constituant la phase gazeuse et les conditions de température et de pression régnant dans le four déterminent la nature de la matrice formée au sein des pièces en matériau composite.

Par exemple, les documents KR2019/068323 et FR 2700330 décrivent des procédés d'infiltration chimique en phase vapeur.

Une des limites des procédés d'infiltration chimique en phase vapeur est le fait qu'il est difficile de densifier le cœur de la préforme fibreuse. En effet, comme décrit plus haut, la matrice se forme directement dans la porosité du substrat au cours du procédé par décomposition de la phase gazeuse réactive. Cette décomposition obstrue au cours du procédé la porosité proche de la surface des préformes fibreuses, ce qui rend plus difficile l'accès de la phase gazeuse à la porosité au cœur des préformes. De plus, la phase gazeuse qui atteint le cœur est moins riche en réactifs, car une partie s'est déjà décomposée en surface. Plus le procédé avance, plus la densification du cœur devient difficile, jusqu'à ce que la porosité de surface soit complètement obstruée et que la densification du cœur devienne impossible. Il en résulte une porosité résiduelle importante dans la pièce obtenue.

Pour améliorer la densification du cœur des préformes, il est généralement proposé de tirer parti de la cinétique de la réaction de formation de la matrice. Par exemple, en assurant un gradient de température entre le cœur des préformes et leurs surfaces, la matrice se dépose plus rapidement au cœur plus chaud de la préforme, avant de se déposer dans la porosité plus proche de la surface ce qui permet d'améliorer la densification du cœur des préformes.

Créer les gradients thermiques nécessaires pour la mise en place de la solution proposée ci-dessus est relativement aisé lorsque les préformes sont conductrices, par exemple lorsque les préformes sont composées de carbone, car il est alors possible de le générer le gradient par couplage inductothermique.

En revanche, il n'est pas possible de créer un couplage inductothermique dans le cas de préformes céramiques car ces dernières ne conduisent pas le courant. Il demeure donc un besoin pour un procédé d'infiltration chimique en phase vapeur permettant d'améliorer le taux de densification obtenu pour des préformes céramiques.

### Exposé de l'invention

Les inventeurs proposent un procédé apportant une solution aux problèmes décrits ci-dessus.

Pour cela, ils proposent un procédé de densification par infiltration chimique en phase vapeur d'une pluralité de préformes fibreuses disposées dans l'enceinte d'un four de densification, le procédé comprenant au moins les étapes a) et b) suivantes, chacune étant répétée plus d'une fois :
a) l'introduction d'une première phase gazeuse dont la décomposition thermique permet de former la matrice dans la porosité de la pluralité de préformes fibreuses ;
b) l'introduction d'une deuxième phase gazeuse réalisée conjointement à une mise en dépression de l'enceinte du four, de sorte que l'introduction de la deuxième phase gazeuse soit conjointe à l'expulsion de la première phase gazeuse hors de l'enceinte, la température de la deuxième phase gazeuse étant inférieure ou égale à 25 °C lors de son introduction dans l'enceinte du four.

Les inventeurs ont constaté qu'un tel procédé, et notamment l'introduction de la deuxième phase gazeuse à la température indiquée permet de refroidir temporairement la surface des préformes fibreuses et d'ainsi créer un gradient thermique à la surface de la préforme fibreuse. La cinétique de la réaction de formation de la matrice est alors diminuée en surface de la préforme mais pas au cœur de la préforme qui reste plus chaud, et la densification devient plus rapide au cœur de la préforme qu'en surface. Il en résulte un procédé de densification permettant d'obtenir des taux de porosité résiduelle qui ne sont pas atteignables pour des procédés de densification classiques isotherme et isobare.

De plus, la purge des gaz réactifs contenus dans la première phase gazeuse, réalisées en même temps que le refroidissement des préformes, permet d'assurer que la première phase gazeuse soit toujours riche en gaz réactifs. Enfin, la répétition des étapes a) et b), de manière alternée, permet d'assurer que le gradient de température souhaité entre le cœur et la surface des préformes fibreuses soit présent tout au long de la réalisation du procédé.

Dans un mode de réalisation, les préformes comprennent des fibres de carbure de silicium, voire sont constituées de fibres de carbure de silicium.

Le procédé est en effet particulièrement avantageux dans le cas de préformes en fibres de SiC, car c'est pour ces dernières qu'il est impossible de créer un gradient thermique par couplage inductif. En effet, de telles préformes ne sont pas conductrices de courant.

Dans un mode de réalisation, la première phase gazeuse comprend du méthyltrichlorosilane et de l'hydrogène. Ces composés permettent de former une matrice de carbure de silicium SiC. Dans un mode de réalisation, les préformes comprennent des fibres de carbure de silicium, voire sont constituées de fibres de carbure de silicium, et le procédé permet alors de former des matériaux composites SiC/SiC dont la porosité résiduelle est particulièrement diminuée comparativement à ceux qui peuvent être obtenus avec les procédés de l'art antérieur.

Dans un mode de réalisation, la deuxième phase gazeuse comprend de l'hydrogène, de l'hélium, de l'azote ou un mélange de ces composés. D'une part de tels composés sont avantageux car ils ne risquent pas de former des sous-produits non-souhaités dans l'enceinte du four de densification. D'autre part, ces composés ont une très bonne conductivité thermique, ce qui permet de former le gradient thermique souhaité à la surface des préformes tout en minimisant la durée de l'étape b), ce qui diminue par conséquent la durée du procédé de densification.

Dans un mode de réalisation, la pression appliquée dans l'enceinte du four au cours de l'étape b) est inférieure ou égale à 200 mbar. Une pression réduite dans l'enceinte du four permet de purger la première phase gazeuse au moment de l'introduction de la deuxième phase gazeuse.

Dans un mode de réalisation, une étape b) est interrompue par une nouvelle étape a) lorsque la température à la surface des préformes fibreuses est inférieure ou égale à 800°C.

Par exemple, la température à la surface des préformes fibreuses peut être mesurées par un pyromètre infrarouge. Le contrôle de la température de surface des préformes fibreuses permet d'assurer que le gradient thermique entre le cœur et la surface soit celui souhaité pour le procédé de densification. Notamment, les inventeurs ont constatés qu'une température de surface des préformes fibreuses inférieures ou égale à 800°C, avec des conditions de densification par ailleurs conformes à celles de l'art antérieur, représente un gradient thermique optimal permettant un gain de densification des préformes tout en assurant également que les étapes de refroidissement ne soient pas trop longues.

Dans un mode de réalisation, la température de consigne de l'enceinte du four de densification peut être inférieure ou égale à 1100°C pendant les étapes a), par exemple comprise entre 800°C et 1100°C.

Dans un mode de réalisation, une étape a) peut être interrompue par une étape b) lorsque la température à la surface des préformes est supérieure ou égale à 1000°C. En effet, si la température de surface des préformes devient trop importante, alors le gradient thermique entre le cœur et la surface est inférieur à celui souhaité et la densification n'est pas optimale.

Dans un mode de réalisation, la durée des étapes b) est inférieure ou égale à 5 minutes. Les inventeurs ont constatés qu'une telle durée des étapes b) de refroidissement permettait d'obtenir un gradient thermique suffisant pour obtenir à la fin du procédé le gain de densification souhaité.

Dans un mode de réalisation, la circulation des deux phases gazeuses est à co-courant. Dans ce mode de réalisation, les deux phases gazeuses suivent un trajet similaire dans le four, et notamment dans les préformes fibreuses.

Dans ce cas, le refroidissement induit par l'introduction de la deuxième phase gazeuse lors de la phase b) agit de manière plus efficace sur la zone du réacteur où la cinétique de dépôt est la plus importante lors de la phase a) du fait de la richesse des gaz réactifs.

Dans un mode de réalisation, la circulation des deux phases gazeuses est à contre-courant l'une de l'autre. Dans ce mode de réalisation, la première et la deuxième phase gazeuse suivent un trajet inverse dans l'enceinte du four de densification, et notamment dans les préformes fibreuses.

Dans ce cas, la circulation en sens contraire de la deuxième phase gazeuse lors de l'étape b) aura pour effet de casser la couche limite entourant les préformes fibreuses, ce qui, en plus de refroidir les pièces, facilitera le renouvèlement de la première phase gazeuse lors de l'étape a).

Dans un mode de réalisation une quantité calibrée de première phase gazeuse est introduite lors de chaque étape a). Par exemple, le circuit d'introduction de la première phase gazeuse comprend une chambre de réserve en amont du four de densification assurant que la quantité de première phase gazeuse délivrée au cours de chaque étape a) soit limitée à la quantité contenue dans cette chambre de réserve.

Ce mode de réalisation permet de connaître précisément la quantité de première phase gazeuse introduite dans l'enceinte du four de densification au moment de chaque étape a), et par conséquent de limiter la durée de chaque étape a) au temps nécessaire pour la décomposition de cette quantité de première phase gazeuse introduite. Il en résulte un procédé dont la durée de chaque étape a) peut être précisément connue, et relativement courte.

Par exemple, dans ce mode de réalisation, la durée de chaque étape a) peut être inférieure ou égale à une minute, voire inférieure ou égale à 30 secondes.

Dans un mode de réalisation, le débit de première phase gazeuse est constant au cours de chaque étape a).

Ce mode de réalisation permet un renouvellement constant de la première phase gazeuse de sorte qu'elle soit donc constamment chargée en espèces réactives, et ainsi, la durée de l'étape a) n'est pas limitée par l'appauvrissement de la première phase gazeuse en espèces réactives. Dans ce mode de réalisation, la durée de l'étape a) est donc limitée par la durée du réchauffement des surfaces des préformes fibreuses.

Dans un tel mode de réalisation, la durée de chaque étape a) peut être comprise entre 1 et 30 minutes, par exemple entre 3 et 10 minutes.

### Brève description des dessins

[Fig. 1] La figure 1 représente schématiquement une installation pour la réalisation d'un procédé de l'invention.
[Fig. 2] La figure 2 représente schématiquement l'évolution de grandeurs caractéristiques dans un premier mode de réalisation du procédé.
[Fig. 3] La figure 3 représente schématiquement l'évolution de grandeurs caractéristiques dans un deuxième mode de réalisation du procédé.

### Description des modes de réalisation

L'invention est à présent décrite au moyen de figures qui ne sont présentes qu'afin de mieux décrire certains modes de réalisation et qui ne doivent pas être interprétées de manière limitative.

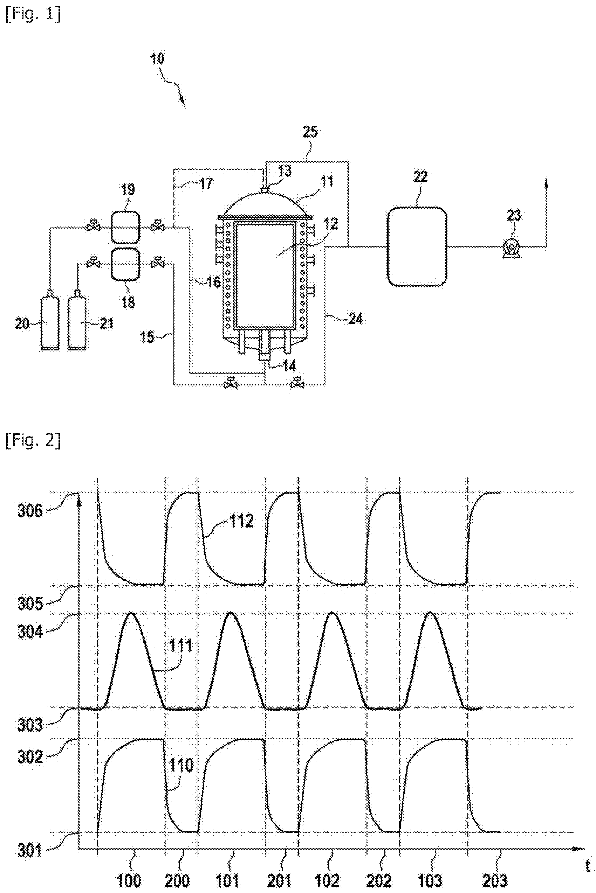

La figure 1 représente de manière schématique une installation 10 permettant la réalisation d'un procédé décrit ci-dessus. L'installation 10 comprend un four de densification 11, délimitant une enceinte 12. L'enceinte 12 du four de densification 11 est chargée avec les préformes fibreuses à densifier, non représentées.

Comme décrit plus haut, le procédé comprend ensuite la répétition des étapes a) et b) décrites plus haut.

Par exemple, les étapes a) et b) peuvent être répétées au moins 5 fois, voire au moins 10 fois. Le nombre de répétitions est conditionné par la quantité de céramique à déposer.

A chaque fois qu'une étape a) est réalisée la densification de la préforme augmente. De plus, comme indiqué, l'étape b) permet d'assurer qu'un gradient thermique existe entre le cœur et la surface des préformes de sorte que la décomposition thermique de la première phase gazeuse ait lieu plus rapidement dans le cœur des préformes qu'à leurs surfaces.

Par exemple, l'installation 10 comprend une source de la première phase gazeuse 20 et une source de la deuxième phase gazeuse 21. Ces sources en phase gazeuse 20, 21 sont en communication fluidique, au moyen des conduites 16 et respectivement 15 avec l'entrée 14 située en bas du four 11.

L'ensemble des chemins d'alimentation allant des sources 20, 21 à l'enceinte 12 peuvent comprendre des vannes, comme représentées.

Dans un mode de réalisation, la première phase gazeuse a une température comprise supérieure ou égale à 1000°C, voire supérieure ou égale à 1100°C lors de l'alimentation de l'enceinte 12. Si nécessaire, des moyens de chauffage non représentés en figure 1 peuvent être présents. Par exemple, les gaz réactifs peuvent être préchauffés à l'extérieur de l'enceinte.

L'installation 10 comprend en outre des pompes, et d'autres moyens non représentés permettant l'alimentation de l'enceinte par les premières et deuxièmes phases gazeuses depuis les sources 20 et 21 respectivement.

Dans un mode de réalisation représenté, le chemin d'alimentation en phase gazeuse allant des sources 20, 21 à l'enceinte 12 peut comprendre en outre une chambre de réserve 18, 19, sur le chemin de la deuxième ou respectivement de la première phase gazeuse. Une telle chambre de réserve peut être utile dans un mode de réalisation dans lequel on souhaite introduire une quantité déterminée de première ou de deuxième phase gazeuse, ainsi qu'il sera décrit ci-après.

Dans d'autres modes de réalisation, ces chambres de réserves 18, 19 peuvent être absentes.

Dans le mode de réalisation représenté en traits pleins en figure 1, les conduites 15 et 16 d'alimentation en première et en deuxième phase gazeuse, alimentent le four par la même extrémité 14, ici l'extrémité située en bas du four 11. De telles conduites 15 et 16 permettent donc une alimentation du four avec une première et une deuxième phase gazeuse à co-courant.

Dans un mode de réalisation alternatif, figuré en trait pointillé, la conduite d'alimentation en première phase gazeuse 17 peut être reliée à une extrémité du four 11 opposée à l'extrémité alimentée par la deuxième phase gazeuse. Sur la figure 1, et dans l'alternative en pointillés, la première phase gazeuse alimente l'enceinte 12 du four 11 par son extrémité 13 située en haut, et la deuxième phase gazeuse alimente l'enceinte 12 du four 11 par l'extrémité 14 située en bas, via la conduite d'alimentation 15.

Un tel mode de réalisation permet aux première et deuxième phases gazeuse de circuler dans l'enceinte 12 à contre-courant l'une de l'autre.

Bien entendu, on ne sort pas du cadre de l'invention, si l'alimentation de l'enceinte par les premières ou deuxièmes phases gazeuses est différente de celles représentées. Par exemple, dans le cas où l'alimentation en première et en deuxième phase gazeuse à lieu par l'extrémité 13 située en haut du four 11.

De même, la figure 1 représente, des circuits d'évacuation 24, 25 de la phase gazeuse en dehors du four. Bien que deux circuits soient représentés sur la figure 1, on ne sort pas du cadre de l'invention lorsqu'un seul de ces deux circuits est présent.

Ces circuits permettent à la première et/ou deuxième phase gazeuse d'être évacuées de l'enceinte 12 du four 11.

Comme décrit plus haut, une étape b) d'alimentation de l'enceinte 12 en deuxième phase gazeuse doit être réalisée conjointement à la mise en dépression de l'enceinte 12, de sorte que l'introduction de la deuxième phase gazeuse soit conjointe à l'expulsion de la première phase gazeuse hors de l'enceinte 12.

Pour cela, les circuits d'évacuation 24, 25 peuvent par exemple être reliés à une chambre 22 de pression réduite. De la sorte, lorsque l'évacuation de l'enceinte 12 est souhaitée, la chambre de pression réduite est mise en communication fluidique avec l'enceinte 12. La chambre de pression réduite 22 a une pression inférieure à celle régnant dans l'enceinte 12, et la phase gazeuse présente est alors évacuée.

Par exemple, la chambre de pression réduite 22 peut être reliée à une pompe 23, permettant de faire le vide dans la chambre de pression réduite 22.

Dans un mode de réalisation non représenté, l'enceinte 12 peut être purgée lorsque cela est nécessaire, directement par une pompe.

Comme décrit plus haut, le procédé de l'invention comprend une répétition des étapes a) et b).

La figure 2 décrit, de manière schématique, l'évolution de la pression partielle de première phase gazeuse 110, du débit de première phase gazeuse 111 et de pression partielle de deuxième phase gazeuse 112 dans l'enceinte 12 au cours de la réalisation d'un procédé.

La figure 2 décrit plus précisément un mode de réalisation dans lequel l'étape a) est réalisée en introduisant une quantité calibrée de première phase gazeuse dans l'enceinte 12 de réaction.

Par exemple, une première étape a) peut être réalisée en amenant la chambre de réserve 19 d'un volume connu à une pression donnée, puis en alimentant l'enceinte 12 avec le contenu de cette chambre de réserve 19, sans autre apport de première phase gazeuse. La réalisation de cette première étape a) sur une durée 100, cause un débit de première phase gazeuse 111 variant entre zéro 303 et une valeur maximale 304, comme représenté sur la figure 2.

De même, la pression partielle de première phase gazeuse 110 varie entre zéro 301 et une valeur maximale 302.

Au bout d'une durée choisie 100, une étape b) commence.

De manière alternative, la durée 100 de l'étape a) peut être déterminée en suivant l'évolution de la température à la surface des préformes fibreuses, et l'étape a) est interrompue lorsque la température de surface devient trop importante, par exemple supérieure ou égale à 1000 °C.

Ce mode de réalisation permet d'assurer que le gradient thermique entre le cœur des préformes et leurs surfaces soit toujours suffisant pour assurer que la formation de matrice ait préférentiellement lieu au cœur des préformes.

L'étape b) correspond à l'introduction d'une deuxième phase gazeuse, occasionnant une augmentation de la pression partielle de la deuxième phase gazeuse 112 entre zéro 305 et une valeur maximale 306.

Cette étape comprend aussi une mise en dépression de l'enceinte 12. Ainsi, conjointement à l'augmentation de la pression partielle de la deuxième phase gazeuse 112, on observe une diminution rapide de la pression partielle de première phase gazeuse 110, et un retour à zéro 303 du débit de première phase gazeuse 111.

Au bout d'une durée 200 déterminée, une étape a) commence à nouveau.

De manière alternative, on peut interrompre l'étape b) lorsque la température de surface des préformes fibreuses redevient inférieure à une valeur cible, par exemple inférieure ou égale à 800°C. Cela permet d'assurer que le gradient thermique souhaité entre l'intérieur et l'extérieur des préformes fibreuses soit suffisant pour obtenir le dépôt préférentiel de la matrice au cœur des préformes fibreuses tout en faisant durer l'étape b) aussi peu de temps que nécessaire.

La figure 2 représente une alternance de quatre étapes a) 100, 101, 102, 103 et b) 200, 201, 202, 203, mais l'on ne sort pas du cadre de l'invention si un nombre différent d'étapes a) et b) est choisi.

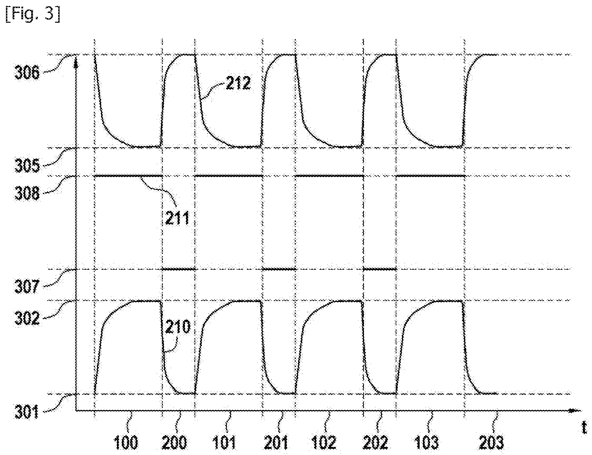

La figure 3 représente, de manière schématique, l'évolution de la pression partielle de première phase gazeuse 210, du débit de première phase gazeuse 211 et de pression partielle de deuxième phase gazeuse 212 dans l'enceinte 12 au cours de la réalisation d'un procédé dans un autre mode de réalisation, dans lequel le débit de première phase gazeuse est constant au cours des étapes a).

Dans un tel mode de réalisation, à la différence du mode de réalisation représenté en figure 2, l'enceinte 12 est alimentée par un débit de première phase gazeuse 211 variant entre zéro 307 lors des étapes b), et une valeur constante 308 lors des étapes a).

Ce mode de réalisation peut être obtenu en l'absence de la chambre de réserve 19 permettant d'alimenter l'enceinte 12 avec une quantité calibrée de première phase gazeuse. Par exemple, dans un tel mode de réalisation, la source 20 de première phase gazeuse peut alimenter directement l'enceinte 12 lors des étapes a).

La figure 3 représente une première étape a), au cours de laquelle le débit 211 en première phase gazeuse est constant, et d'une valeur choisie 308. Cette étape permet la densification des préformes pendant une durée 100.

Puis, après cette étape a), une étape b) peut être réalisée, au cours de laquelle le débit 211 en première phase gazeuse est nul 307. La pression partielle en première phase gazeuse 210 diminue, en même temps que la pression partielle en deuxième phase gazeuse 212 augmente dans l'enceinte 12.

Cette étape b) permet de purger l'enceinte 12 de la première phase gazeuse, et de restaurer le gradient thermique nécessaire entre le cœur et la surface des préformes fibreuses.

La figure 3 représente une alternance de quatre étapes a) 100, 101, 102, 103 et b) 200, 201, 202, 203, mais l'on ne sort pas du cadre de l'invention si un nombre différent d'étapes a) et b) est choisi.

## Revendications

1. Procédé de densification par infiltration chimique en phase vapeur d'une pluralité de préformes fibreuses disposées dans l'enceinte (12) d'un four de densification (11), **caractérisé en ce que** le procédé comprenant au moins les étapes a) et b) suivantes, chacune étant répétée plus d'une fois :
a) l'introduction d'une première phase gazeuse dont la décomposition thermique permet de former la matrice dans la porosité de la pluralité de préformes fibreuses ;
b) l'introduction d'une deuxième phase gazeuse réalisée conjointement à une mise en dépression de l'enceinte du four, de sorte que l'introduction de la deuxième phase gazeuse soit conjointe à l'expulsion de la première phase gazeuse hors de l'enceinte, la température de la deuxième phase gazeuse étant inférieure ou égale à 25 °C lors de son introduction dans l'enceinte du four.

2. Procédé de densification selon la revendication 1, dans lequel les préformes fibreuses comprennent des fibres de carbure de silicium.

3. Procédé de densification selon la revendication 1 ou 2, dans lequel la première phase gazeuse comprend du méthyltrichlorosilane et de l'hydrogène.

4. Procédé de densification selon l'une quelconque des revendications 1 à 3, dans lequel la deuxième phase gazeuse comprend de l'hydrogène, de l'hélium, de l'azote ou un mélange de ces composés.

5. Procédé de densification selon l'une quelconque des revendications 1 à 4, dans lequel la pression appliquée dans l'enceinte (12) du four (11) au cours de l'étape b) est inférieure ou égale à 200 mbar.

6. Procédé de densification selon l'une quelconque des revendications 1 à 5, dans lequel la durée des étapes b) est inférieure ou égale à 5 minutes.

7. Procédé de densification selon l'une quelconque des revendications 1 à 6, dans lequel une étape b) est interrompue par une nouvelle étape a) lorsque la température à la surface des préformes fibreuses est inférieure ou égale à 800°C.

8. Procédé de densification selon l'une quelconque des revendications 1 à 7, dans lequel la circulation des deux phases gazeuses a lieu à co-courant.

9. Procédé de densification selon l'une quelconque des revendications 1 à 7, dans lequel la circulation des deux phases gazeuses a lieu à contre-courant l'une de l'autre.

10. Procédé de densification selon l'une quelconque des revendications 1 à 9, dans lequel une quantité calibrée de première phase gazeuse est introduite lors de chaque étape a).

11. Procédé de densification selon l'une quelconque des revendications 1 à 9, dans lequel le débit de première phase gazeuse est constant au cours de chaque étape a).

## Patentansprüche

1. Verfahren zur Verdichtung durch chemische Dampfinfiltration einer Vielzahl von Faservorformlingen, die in der Kammer (12) eines Verdichtungsofens (11) angeordnet sind, **dadurch gekennzeichnet, dass** das Verfahren mindestens die folgenden Schritte a) und b) umfasst, die jeweils mehr als einmal wiederholt werden:
a) Zuführen einer ersten Gasphase, deren thermische Zersetzung ermöglicht, die Matrix in der Porosität der Vielzahl von Faservorformlingen zu bilden;
b) Zuführen einer zweiten Gasphase, das gleichzeitig mit einer Druckentlastung der Ofenkammer erfolgt, so dass die Zuführung der zweiten Gasphase gleichzeitig mit dem Ausstoßen der ersten Gasphase aus der Kammer erfolgt, wobei die Temperatur der zweiten Gasphase beim Zuführen in die Ofenkammer kleiner als oder gleich wie 25 °C ist.

2. Verfahren zur Verdichtung nach Anspruch 1, wobei die Faservorformlinge Siliciumcarbidfasern umfassen.

3. Verfahren zur Verdichtung nach Anspruch 1 oder 2, wobei die erste Gasphase Methyltrichlorsilan und Wasserstoff umfasst.

4. Verfahren zur Verdichtung nach einem der Ansprüche 1 bis 3, wobei die zweite Gasphase Wasserstoff, Helium, Stickstoff oder ein Gemisch dieser Verbindungen umfasst.

5. Verfahren zur Verdichtung nach einem der Ansprüche 1 bis 4, wobei der Druck, der in Kammer (12) des Ofens (11) während Schritt b) angewandt wird, kleiner als oder gleich wie 200 mbar beträgt.

6. Verfahren zur Verdichtung nach einem der Ansprüche 1 bis 5, wobei die Dauer von Schritt b) kleiner als oder gleich wie 5 Minuten ist.

7. Verfahren zur Verdichtung nach einem der Ansprüche 1 bis 6, wobei ein Schritt b) durch einen neuen Schritt a) unterbrochen wird, wenn die Temperatur an der Oberfläche der Faservorformlinge kleiner als oder gleich wie 800 °C beträgt.

8. Verfahren zur Verdichtung nach einem der Ansprüche 1 bis 7, wobei die Zirkulation der zwei Gasphasen im Gleichstrom erfolgt.

9. Verfahren zur Verdichtung nach einem der Ansprüche 1 bis 7, wobei die Zirkulation der zwei Gasphasen im Gegenstrom zueinander erfolgt.

10. Verfahren zur Verdichtung nach einem der Ansprüche 1 bis 9, wobei eine kalibrierte Menge der ersten Gasphase bei jedem Schritt (a) zugeführt wird.

11. Verfahren zur Verdichtung nach einem der Ansprüche 1 bis 9, wobei die Durchflussrate der ersten Gasphase bei jedem Schritt a) konstant ist.

## Claims

1. A method for densification by Chemical Vapor Infiltration of a plurality of fibrous preforms arranged in the enclosure (12) of a densification furnace (11), the method comprising at least the following steps a) and b), each being repeated more than once:
a) introducing a first gaseous phase, the thermal decomposition of which allows the matrix to form in the pores of the plurality of fibrous preforms;
b) introducing a second gaseous phase while simultaneously placing the enclosure of the furnace under vacuum, such that the introduction of the second gaseous phase takes place at the same time as the expulsion of the first gaseous phase out of the enclosure, the temperature of the second gaseous phase being less than or equal to 25°C when it is introduced into the enclosure of the furnace.

2. The densification method according to claim 1, in which the fibrous preforms comprise silicon carbide fibers.

3. The densification method according to claim 1 or 2, in which the first gaseous phase comprises methyltrichlorosilane and hydrogen.

4. The densification method according to any one of claims 1 to 3, in which the second gaseous phase comprises hydrogen, helium, nitrogen or a mixture of these substances.

5. The densification method according to any one of claims 1 to 4, in which the pressure applied in the enclosure (12) of the furnace (11) during the step b) is less than or equal to 200 mbar.

6. The densification method according to any one of claims 1 to 5, in which the duration of the steps b) is less than or equal to 5 minutes.

7. The densification method according to any one of claims 1 to 6, in which a step b) is interrupted by a new step a) when the temperature at the surface of the fibrous preforms is less than or equal to 800°C.

8. The densification method according to any one of claims 1 to 7, in which the two gaseous phases circulate co-currently.

9. The densification method according to any one of claims 1 to 7, in which the two gaseous phases circulate counter-current to each other.

10. The densification method according to any one of claims 1 to 9, in which a calibrated quantity of first gaseous phase is introduced during each step a).

11. The densification method according to any one of claims 1 to 9, in which the flow rate of first gaseous phase is constant during each step a).
